# EUROPEAN PATENT SPECIFICATION

(11) **EP 2 164 161 B1**
(45) Date of publication and mention of the grant of the patent: **10.09.2014**
(21) Application number: 09009378.2
(22) Date of filing: 20.07.2009
(51) Int. Cl.: H02M 7/217

(54) **AC/DC converter for a compressor driver and air conditioner with a troubleshooting mechanism for faulty bidirectional switches**
Wechselstrom/Gleichstrom-Wandler für einen Kompressorantrieb und eine Klimaanlage mit Fehlerbehandlungsmöglichkeit im Fall von defekten bidirektionalen Schaltern
Convertisseur CA/CC pour une commande de compresseur et climatiseur avec la possibilité de traitement des erreurs dans le cas des commutateurs bidirectionnels en panne

(30) Priority: 11.09.2008 JP 2008233280
(43) Date of publication of application: 17.03.2010
(73) Proprietor: Mitsubishi Electric Corporation, Tokyo 100-8310 (JP)
(72) Inventor: Kashima, Mitsuo, Chiyoda-ku Tokyo 100-8310 (JP)
(74) Representative: Pfenning, Meinig & Partner GbR

(56) References cited:
- JP-A- 2005 160 214
- JP-A- 2008 022 625
- JP-A- 2008 099 512
- BACKMAN N ET AL: "Modern circuit topology enables compact power factor corrected three-phase rectifier module", 29 September 2002 (2002-09-29), INTELEC 2002. 24TH. INTERNATIONAL TELECOMMUNICATIONS ENERGY CONFERENCE. MONTREAL, QUEBEC, CANADA, SEPT. 29 - OCT. 3, 2002; [INTELEC. INTERNATIONAL TELECOMMUNICATIONS ENERGY CONFERENCE], NEW YORK, NY : IEEE, US, PAGE(S) 107 - 114, XP010614608, ISBN: 978-0-7803-7512-3 * abstract * * pages 7-3, left-hand column * * figures 2,10 *

## Description

### BACKGROUND OF THE INVENTION

### 1. Field of the Invention

The present invention relates to an apparatus for converting an alternating current to a direct current, a compressor driving apparatus using the apparatus, and an air conditioner.

### 2. Description of the Invention

JP 2005160214 A describes a power conversion apparatus comprising a main circuit switch and a reactor, a converter, an inverter, an inverter abnormality detection part, a converter voltage abnormality detection part, an inverter current abnormality detection part, and a control part. The converter comprises a diode bridge, capacitors and a bidirectional switch.

JP 2008099512 A describes a power supply unit comprising a rectifying circuit, a capacitor circuit, which consists of a plurality of capacitors connected in series and is connected between two output terminals of the rectifying circuit, a first switching means connected between one input terminal of the rectifying circuit and one connection point between the capacitors with the capacitor circuit, a second switching means connected between the other input terminal of the rectifier circuit and one connection point, between the capacitors within the capacitor circuit and a zero-cross detecting means for detecting a zero-cross point of an AC power source.

Backman N. et al., "Modern circuit topology enables compact power factor corrected three-phase rectifier module", Intelec 2002, 24th International Telecommunications Energy Conference, Montreal, Quebec, Canada, Sept. 29 - Oct. 3, 2002 [Intelec. International Telecommunications Energy Conference], New York, NY: IEEE, US, vol. Conf. 24, 29 September 2002 (2002-09-29), pages 107-114, XP010614608, DOI:DOI:10.1109/Intlec.2002.1048642, ISBN: 978-0-7803-7512-3 describes a three-phase power factor corrected rectifier for telecom applications.

Conventionally, as to an alternating current/direct current conversion apparatus (hereinafter, referred to as AC/DC converter), the document JP 2008022625 A discloses an AC/DC converter comprising:
a rectifier connected to an alternating current power supply through a reactor;
a capacitor series circuit composed of capacitors connected in series between the output terminals of the rectifier;
a first bidirectional switch having one end connected to one input terminal of the rectifier;
a second bidirectional switch having one end connected to the other input terminal of the rectifier;
a control means for controlling the operation of the first bidirectional switch and the second bidirectional switch, and a
voltage detection means for detecting at least two voltage values.

This conventional AC/DC converter has such an arrangement that "a reactor is connected between a single-phase AC power supply and one of alternating current inputs of a full-wave rectifier circuit composed of diodes, a capacitor series circuit is connected between the direct current outputs of the full-wave rectifier circuit, bidirectional switches 10, 11 are connected between an internal connection point of the capacitor series circuit and the respective alternating current inputs of the full-wave rectifier circuit, and a load 14 is connected in parallel with the capacitor series circuit, respectively, wherein the voltages of capacitors 12, 13 connected in series are detected and the bidirectional switches 10 and 11 are turned on and off at a high frequency so that the voltages are made uniform" as a technique for solving a problem such that "in a configuration in which a single-phase AC power supply, a full-wave rectifier circuit composed of diodes, a reactor, a capacitor series circuit, bidirectional switches, and a load are connected, when the power factor of an input alternating current is increased by switching the bidirectional switches, the voltages of capacitors connected in series become imbalanced in a half-cycle period".

The AC/DC converter described in Japanese Unexamined Patent Application Publication No. 2008-22625 is configured such that the capacitor series circuit is connected between the direct current output terminals of the full-wave rectifier circuit and the bidirectional switches are connected between the internal connection point of the capacitor series circuit and alternating current input terminals of the full-wave rectifier circuit, respectively. Accordingly, application of the AC power supply in a state that any one of the bidirectional switches is in short circuit failure results in a state of a voltage-doubler circuit. Then, there is a possibility that secondary breakdown occurs because a voltage higher than a guaranteed withstanding voltage is applied to parts connected between direct current output terminals of a rectifier circuit.

Further, even if a third bidirectional switch is connected between the internal connection point of the capacitor series circuit and connection points of the bidirectional switches 10, 11, unless a short-circuit failure of the bidirectional switches 10, 11 can be detected before the third bidirectional switch is turned on, a problem remains that the state of the voltage-doubler circuit occurs while the third bidirectional switch is turned on when either of the bidirectional switches 10, 11 is in short circuit failure.

The object of the present invention, which was made to solve the above problems, is to obtain an AC/DC converter capable of detecting a failure of the bidirectional switch.

### SUMMARY OF THE INVENTION

An AC/DC converter according to the present invention is defined in the appended claim 1. Preferred embodiments are defined in the dependent claims.

### Effect of the Invention

According to the AC/DC converter of the present invention, a short circuit failure of the bidirectional switch can be detected based on a result of detection of the voltage detection means paying attention to the feature of the resistor voltages generated when the bidirectional switches are in short circuit failure.

### BRIEF DESCRIPTION OF THE DRAWINGS

Fig. 1 is a circuit diagram of an AC/DC converter according to Embodiment 1.
Fig. 2 is an operation flow of the AC/DC converter according to Embodiment 1.
Fig. 3 shows an example of waveforms of respective portions when a first, second, and third bidirectional switches 4, 5, and 8 are normal.
Fig. 4 shows an example of waveforms of respective portions when the first bidirectional switch 4 is in short circuit failure and the second and third bidirectional switches 5 and 8 are normal.
Fig. 5 shows an example of waveforms of each portion when the second bidirectional switch 5 is in short circuit failure and the first and third bidirectional switches 4 and 8 are normal.
Fig. 6 is a circuit diagram of an AC/DC converter according to Embodiment 2.
Fig. 7 shows an example of waveforms of the respective portions when only a diode 4a in a first bidirectional switch equivalent module 4' is in short circuit failure and a second bidirectional switch equivalent module 5' and a third bidirectional switch 8 are normal.
Fig. 8 is a table enumerating cases in which any one of the first, second, and third bidirectional switches 4, 5, and 8 is in short circuit failure or open circuit failure.
Fig. 9 is an operation flow of an AC/DC converter according to Embodiment 3.
Fig. 10 is an operation flow of an AC/DC converter according to Embodiment 4.
Fig. 11 is an example of waveforms of the respective portions when the first, second and third bidirectional switches 4, 5, 8 are normal.
Fig. 12 is an example of waveforms of the respective portions when the first bidirectional switch 4 is in open circuit failure and the second and third bidirectional switches 5, 8 are normal.
Fig. 13 is an example of waveforms of the respective portions when the second bidirectional switch 5 is in open circuit failure and the first and third bidirectional switches 4, 8 are normal.
Fig. 14 is an example of waveforms of the respective portions when the third bidirectional switch 8 is in short circuit failure and the first and second bidirectional switches 4, 5 are normal.

### DESCRIPTION OF THE PREFERRED EMBODIMENTS

### Embodiment 1

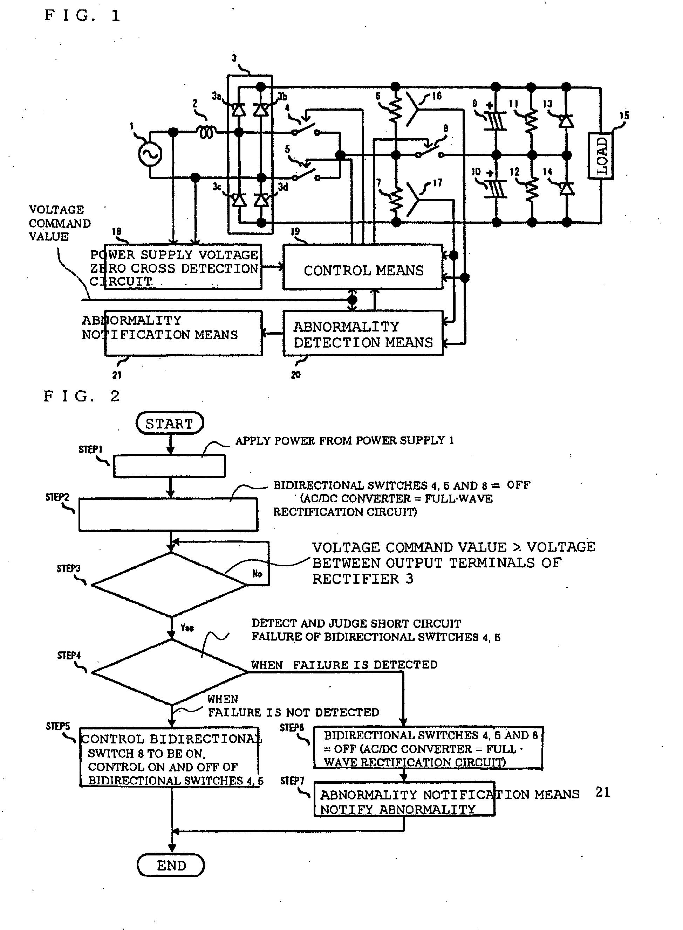

Fig. 1 is a circuit diagram of an AC/DC converter according to Embodiment 1 of the present invention. The AC/DC converter according to Embodiment 1 of the present invention has a reactor 2, a rectifier 3, a first bidirectional switch 4, a second bidirectional switch 5, resistors 6 and 7, a third bidirectional switch 8, capacitors 9 and 10, balance resistors 11 and 12, clamp diodes 13 and 14, a load 15, a first voltage detector 16, a second voltage detector 17, a power supply voltage zero cross detection circuit 18, control means 19, abnormality detection means 20, and abnormality notification means 21.

The reactor 2 is inserted between an alternating current power supply 1 and the rectifier 3. The rectifier 3 is composed of diodes 3a to 3d connected to each other in a bridge state and rectifies and outputs an alternating current supplied by the alternating current power supply 1. One end of the first bidirectional switch 4 is connected to one input terminal of the rectifier 3. One end of the second bidirectional switch 5 is connected to the other input terminal of the rectifier 3.

The resistors 6 and 7 are connected in series between the output terminals of the rectifier 3. The junction of the resistors 6 and 7 is connected to the terminals of the first and second bidirectional switches 4, 5 on the load 15 side thereof. Further, the junction is also connected to the terminal of the third bidirectional switch 8 on the alternating current power supply 1 side thereof. It is assumed that the resistors 6 and 7 have the same resistance value.

The capacitors 9 and 10, the balance resistors 11 and 12, and the clamp diodes 13 and 14 are connected in series between output terminals of the rectifier 3, respectively. The balance resistors 11 and 12 are used to balance the inter-terminal voltages of the capacitors 9 and 10. The clamp diodes 13 and 14 prevent an inverted voltage from being applied between the capacitors 9 and 10 when the alternating current power supply 1 is turned off in a state that the inter-terminal voltages of the capacitors 9 and 10 become imbalanced. It is assumed that the capacitors 9 and 10 have the same capacitance. Further, it is assumed that the resistors 9 and 10 have the same resistance. The junction of the capacitors 9 and 10, the junction of the resistors 11 and 12, and the junction of the diodes 13 and 14 are connected to the terminal of the third bidirectional switch 8 on the load 15 side thereof, respectively.

The load 15 is connected between the output terminals of the rectifier 3, and, for example, an inverter circuit for driving a compressor of an air conditioner and the like is connected therebetween.

A first voltage detector 16 detects the voltage across both ends of the resistor 6. A second voltage detector 17 detects the voltage across both ends of the resistor 7. A power supply voltage zero cross detection circuit 18 detects a voltage zero cross point of the alternating current power supply 1.

Control means 19 controls ON/OFF of the first, second, and third bidirectional switches 4, 5, and 8 based on the voltage command value between the output terminals of the rectifier 3 applied externally, the voltage values detected by the first and second voltage detectors 16 and 17, the output of the power supply zero cross detection circuit, and the output of the abnormality detection means 20 to be described later. The abnormality detection means 20 detects a short circuit failure of the first and second bidirectional switches 4 and 5 using a method which will be explained in Fig. 2 as follows.

The control means 19 and the abnormality detection means 20 may be composed of hardware such as a circuit device for realizing these functions or may be composed of an arithmetic operation unit such as a microcomputer and a CPU (Central Processing Unit) and software for specifying the operation thereof.

When the abnormality detection means 20 detects that the first bidirectional switch 4 or the second bidirectional switch 5 is in short circuit failure, the abnormality notification means 21 notifies that it is abnormal. A method is conceivable in which, for example, an abnormal notification LED (Light Emitting Diode) is provided as means for notifying abnormality, and an abnormality notification LED (not shown) is turned off when the abnormality detection means 20 does not detect the short circuit failure of the first bidirectional switch 4 or the second bidirectional switch 5, and the abnormal notification LED (not shown) is turned on when the short circuit failure of the first bidirectional switch 4 or the second bidirectional switch 5 is detected.

In addition to the above method, any arbitrary methods which employ sound and light, display on a remote controller, display on a display unit connected to the load 15 side, and the like, may be used as long as they can notify whether or not an abnormality occurs and the contents of it to users, administrators or the like.

However, when both first and second bidirectional switches 4, 5 are in short circuit failure, it is almost the same situation as a short-circuit for the alternating current power supply 1 that only reactor 2 is in the circuit, and an excessive current flows, but a secondary breakdown can be prevented because a fuse (not shown) inserted between the alternating current power supply 1 and the rectifier 3 is melted.

The configuration of the AC/DC converter according to Embodiment 1 is explained as described above. Next, an operation of the AC/DC converter according to Embodiment 1 will be explained.

Fig. 2 is an operation flow chart of the AC/DC converter according to Embodiment 1. Each step of Fig. 2 will be explained below.

### (STEP 1)

When a power supply of the AC/DC converter is turned ON, power is applied from the alternating current power supply 1.

### (STEP 2)

The control means 19 controls the first, second and third bidirectional switches 4, 5, and 8 to be an OFF state. As a result, the AC/DC converter operates as a full-wave rectifier circuit.

### (STEP 3)

When a voltage command value applied externally is equal to or lower than the voltage between the output terminals of the rectifier 3, the control means 19 operates the AC/DC converter as the full-wave rectifier circuit. When the voltage command value applied externally is higher than the voltage between the output terminals of the rectifier 3, the process proceeds to STEP 4. The voltage between the output terminals of the rectifier 3 can be obtained from the sum of the voltages detected by the first and second voltage detectors 16 and 17.

### (STEP 4)

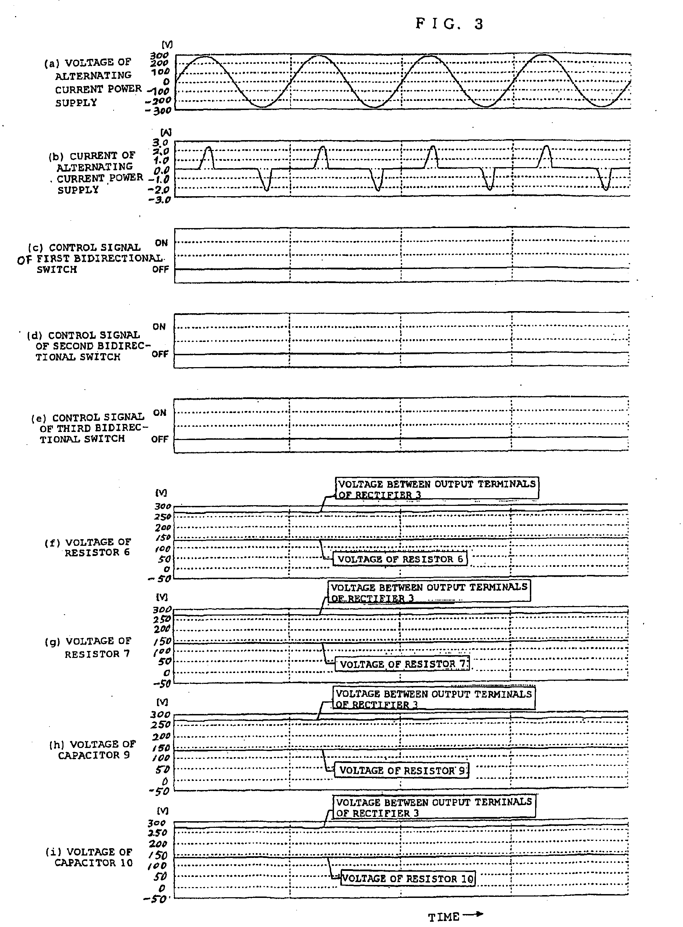

The abnormality detection means 20 judges whether or not the first and second bidirectional switches 4, 5 are in short circuit failure. When the abnormality detection means 20 detects no short circuit failure in the first and second bidirectional switches 4 and 5, the process goes to STEP 5, whereas when it is detected, the process goes to STEP 6. A method of detecting the short circuit failure will be explained again using Figs. 3 to 5 to be described later.

### (STEP 5)

The control means 19 controls the third bidirectional switch 8 to be an ON state and controls ON and OFF of the first and second bidirectional switches 4 and 5 so that the voltage between the output terminals of the rectifier 3 is made to the voltage command value applied externally.

### (STEP 6)

The control means 19 controls the first, second and third bidirectional switches 4, 5, and 8 to be an OFF state. With this operation, the AC/DC converter operates as the full-wave rectifier circuit.

### (STEP 7)

The abnormality notification means 21 notifies abnormality.

When the abnormality detection means 20 detects that the first bidirectional switch 4 or the second bidirectional switch 5 is in short circuit failure and causes the AC/DC converter to operate as the full-wave rectifier circuit, the voltage between the output terminals of the rectifier 3 becomes a value lower than the voltage command value. Accordingly, when, for example, an inverter circuit and the like is connected for driving a compressor of an air conditioner as the load 15, it is preferable to restrict the operation range of the compressor.

The operation of the AC/DC converter according to Embodiment 1 is explained as described above. Next, a method of detecting the short circuit failure at STEP 4 of Fig. 2 will be explained in detail.

When the control means 19 controls the first, second, and third bidirectional switches 4, 5, and 8 to be the OFF state and the absolute value of the difference between the voltage across both ends of the resistor 6 and the voltage across both ends of the resistor 7 is equal to or larger than a predetermined value at STEP 4 of Fig. 2, the abnormality detection means 20 judges that the first bidirectional switch 4 or the second bidirectional switch 5 is in short circuit failure. Waveforms of each portion when the first and second bidirectional switches 4 and 5 are normal and when they are in short circuit failure will be explained in detail using the following Figs. 3 to 5.

Fig. 3 shows an example of the waveforms of each portion when the first, second, and third bidirectional switches 4, 5, and 8 are normal.

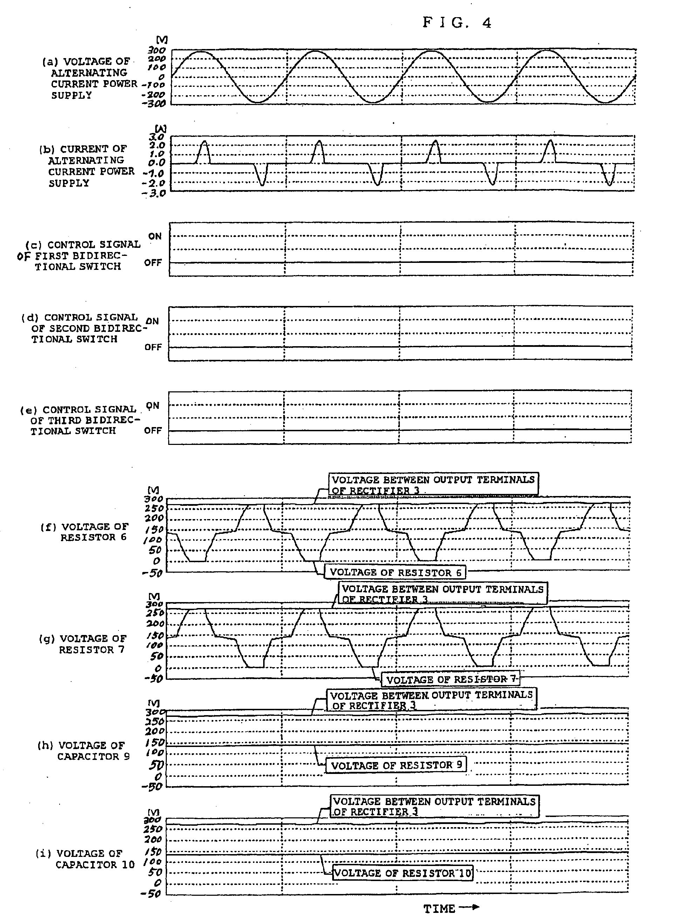

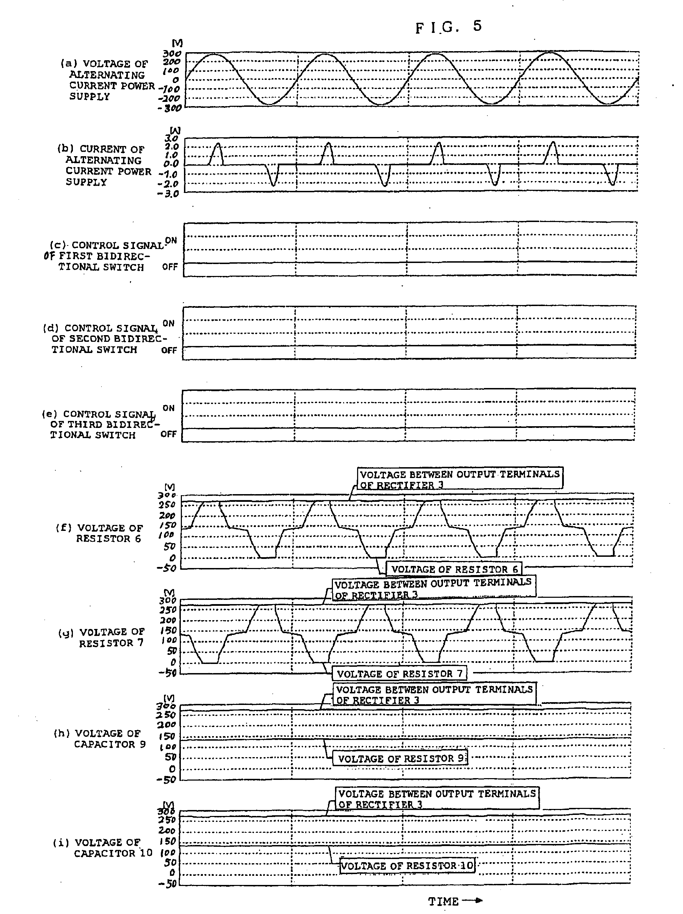

Fig. 4 shows an example of the waveforms of each portion when the first bidirectional switch 4 is in short circuit failure and the second and third bidirectional switches 5 and 8 are normal. Fig. 5 shows an example of the waveforms of each portion when the second bidirectional switch 5 is in short circuit failure and the first and third bidirectional switches 4 and 8 are normal. In the example, it is assumed that AC 200 V is applied as the voltage of the alternating current power supply 1 and a constant load of 100 W is connected as the load 15.

In Figs. 3 to 5, (a) shows a voltage of the alternating current power supply 1, (b) a current of the alternating current power supply 1, (c) a control signal of the first bidirectional switch 4 output from the control means 19, (d) a control signal of the second bidirectional switch 5 output from the control means 19, (e) a control signal of the third bidirectional switch 8 output from the control means 19, (f) a voltage across both the ends of the resistor 6, (g) a voltage across both ends of the resistor 7, (h) a voltage between terminals of the capacitor 9, and (i) shows a voltage between terminals of the capacitor 10. Further, in (f) to (i), a voltage between the output terminals of the rectifier 3 is added.

### (1) When all the bidirectional switches are normal:

When the first, second, and third bidirectional switches 4, 5, and 8 are normal in the state of STEP 2, a voltage one-half the voltage between the output terminals of the rectifier 3 appears to the voltages across both ends of the resistors 6 and 7 as shown in (f) and (g) of Fig. 3.

### (2) When the first bidirectional switch 4 is in short circuit failure:

When the first bidirectional switch 4 is in short circuit failure and the second and third bidirectional switches 5, 8 are normal in the state of STEP 2, a different voltage appears across both ends of the resistors 6 and 7 depending on a voltage state of the alternating current power supply 1 as shown in (f) and (g) of Fig. 4. This is because when the alternating current power supply 1 has positive polarity and when the voltage of the alternating current power supply 1 > the voltage across both ends of the resistor 7, a state occurs in which a current flows along a path in the order of the alternating current power supply 1, the reactor 2, the first bidirectional switch 4 (short circuit failure), the resistor 7, the diode 3d, and the alternating current power supply 1. That is, since a voltage approximately equal to the voltage of the alternating current power supply 1 is applied to both ends of the resistor 7 at that time, the voltage across both ends of the resistor 7 becomes higher than the voltage across both ends of the resistor 6.

Further, when the alternating current power supply 1 has negative polarity and the absolute value of the voltage of the alternating current power supply 1 > the voltage across both ends of the resistor 6, a state occurs in which a current flows along a path in the order of the alternating current power supply 1, the diode 3b, the resistor 6, the first bidirectional switch 4 (short circuit failure), the reactor 2, and the alternating current power supply 1. Accordingly, since a voltage approximately equal to the voltage of the alternating current power supply 1 is applied between both ends of the resistor 6, the voltage across both ends of the resistor 6 becomes higher than the voltage across both ends of the resistor 7.

### (3) When the second bidirectional switch 5 is in short circuit failure:

When the second bidirectional switch 5 is in short circuit failure and the first and third bidirectional switches 4, 8 are normal in the state of STEP 2, a different voltage also appears across both ends of the resistor 6 and 7 depending on a voltage state of the alternating current power supply 1 as shown in (f) and (g) of Fig. 5.

Accordingly, when the absolute value of the difference between the voltage across both ends of the resistor 6 and the voltage across both ends of the resistor 7 is equal to or larger than a predetermined value (for example, 50V) in the state of STEP 2, it can be judged that the first bidirectional switch 4 or the second bidirectional switch 5 is in short circuit failure.

It is explained above that a short circuit failure of each bidirectional switch is detected based on the voltages across both ends of the resistors 6 and 7. On the other hand, it is also considered to detect the short circuit failure of each bidirectional switch based on the voltages between terminals of the capacitors 9 and 10 in place of the above. However, even if the voltages between terminals of the capacitors 9 and 10 are detected, almost no difference is created between the voltages between terminals of the capacitors 9 and 10 regardless of whether the first and second bidirectional switches 4 and 5 are in short circuit failure or not as can be found from (h) and (i) of Figs. 3 to 5. Accordingly, it is difficult to detect that the first and second bidirectional switches 4 and 5 are in short circuit failure based on the voltages between terminals.

Although the voltages across both ends of the resistors 6 and 7 are detected in Embodiment 1, it is needless to say that the same processing can be realized when at least two voltage values of the voltages across both ends of the resistors 6 and 7 and the voltage between the output terminals of the rectifier 3 can be detected. Further, as a method for the abnormality detection means 20 to judge that the first bidirectional switch 4 or the second bidirectional switch 5 is in short circuit failure, it may be judged that the first bidirectional switch 4 or the second bidirectional switch 5 is in short circuit failure when the absolute value of the difference between half of the voltage between the output terminals of the rectifier 3 and the voltage across both ends of the resistor 6 or 7 becomes equal to or larger than a predetermined value.

As described above, in Embodiment 1, when the first bidirectional switch 4 or the second bidirectional switch 5 is in short circuit failure, a different voltage appears across both ends of the resistors 6 and 7 respectively as the voltage of the alternating current power supply 1 varies. The abnormality detection means 20 can detect the short circuit failure of the first bidirectional switch 4 or the second bidirectional switch 5 based on the detected voltages across both ends of the resistors 6 and 7 using the above.

Further, when the abnormality detection means 20 detects the short circuit failure of the first bidirectional switch 4 or the second bidirectional switch 5 in Embodiment 1, the control means 19 turns OFF the first to third bidirectional switches and causes the AC/DC converter to operate as the full-wave rectifier circuit. With this operation, other devices and the like can be prevented from secondary damages.

### Embodiment 2

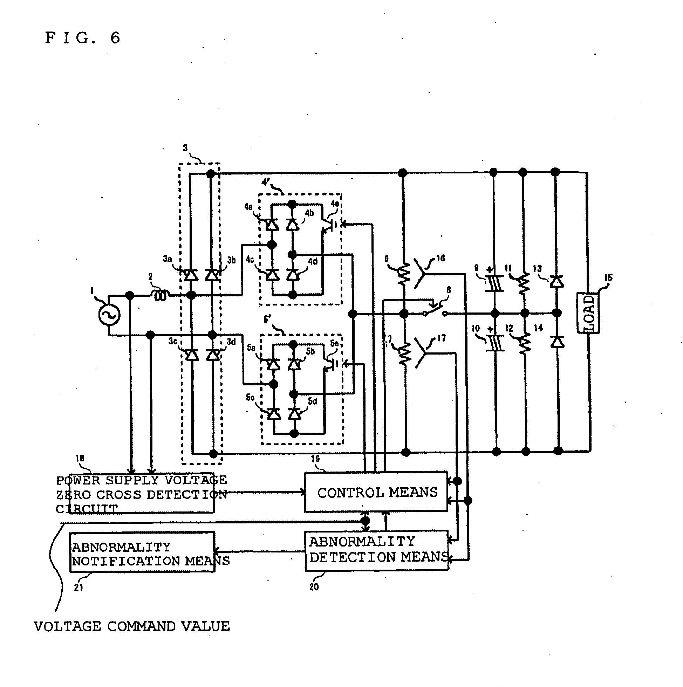

Fig. 6 is a circuit diagram of an AC/DC converter according to Embodiment 2 of the present invention. In Fig. 6, the same components as those of Fig. 1 are denoted by the same reference numerals. A reference numeral 4' denotes a first bidirectional switch equivalent module which is equivalent to the first bidirectional switch 4 in Fig. 1 and is composed of diodes 4a to 4d and a switching element 4e. Reference numeral 5' denotes a second bidirectional switch equivalent module which is equivalent to the second bidirectional switch 5 in Fig. 1 and is composed of diodes 5a to 5d and a switching element 5e. The switching elements 4e and 5e may be composed of, for example, an IGBT (Insulated Gate Bipolar Transistor).

An operation of the AC/DC converter according to Embodiment 2 is the same as that of the AC/DC converter according to Embodiment 1 except that the first and second bidirectional switches 4, 5 of the AC/DC converter according to Embodiment 1 are replaced with the first and second bidirectional switch equivalent modules 4' and 5', respectively.

Next, waveforms of each portion will be explained in detail when the first and second bidirectional switch equivalent modules 4' and 5' are normal and when they are in short circuit failure. The short circuit failure of the switching element in the each bidirectional switch equivalent module will be explained first, and then the short circuit failure of the diode in the respective bidirectional switch equivalent module will be explained.

### (1) Short circuit failure of the switching element in each bidirectional switch equivalent module:

### (1.1) When all the parts are normal;

The waveforms of each portion when the first and second bidirectional switch equivalent modules 4' and 5' and a third bidirectional switch 8 are normal are the same as those of Fig. 3.

### (1.2) When the switching element 4e is at least in short circuit failure;

The waveforms of the each portion when the switching element 4e in the first bidirectional switch equivalent module 4' is at least in short circuit failure and the second bidirectional switch equivalent module 5' and the third bidirectional switch 8 are normal are the same as those of Fig. 4.

### (1.3) When the switching element 5e is at least in short circuit failure;

The waveforms of each portion when the switching element 5e in the second bidirectional switch equivalent module 5' is at least in short circuit failure and the first bidirectional switch equivalent modules 4' and the third bidirectional switch 8 are normal are the same as those of Fig. 5.

However, in Figs. 3 to 5, the control signals of the first and second bidirectional switches 4 and 5 must be replaced with the control signals of the first and second bidirectional switch equivalent modules 4' and 5', respectively.

### (2) Short circuit failure of the diode in each bidirectional switch equivalent module:

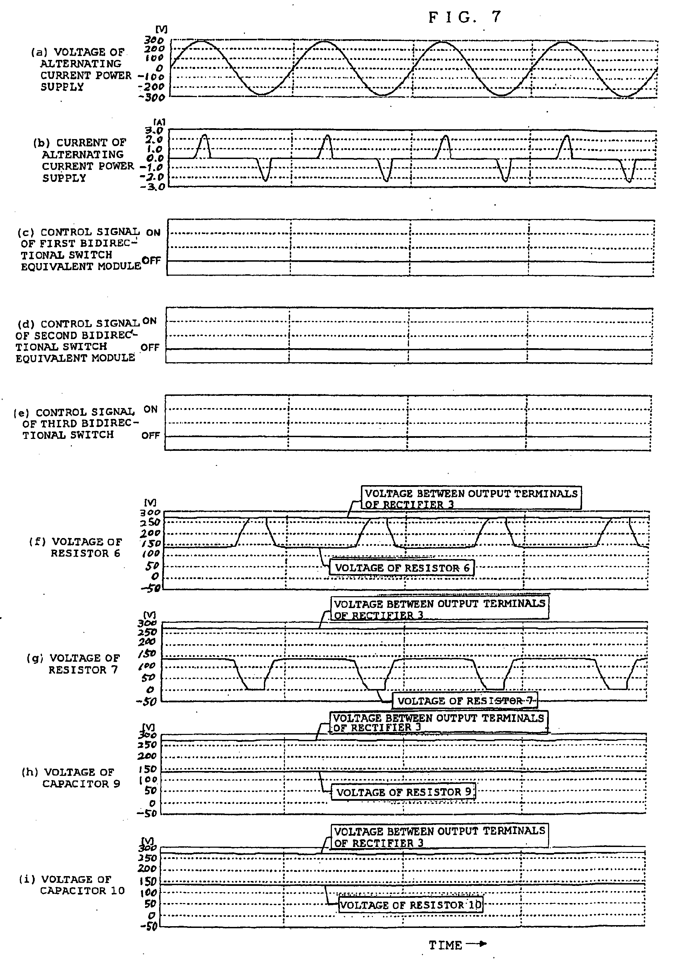

Fig. 7 shows an example of the waveforms of each portion when only the diode 4a in the first bidirectional switch equivalent module 4' is in short circuit failure and the second bidirectional switch equivalent module 5' and the third bidirectional switch 8 are normal. Control means 19 controls the first and second bidirectional switch equivalent modules 4' and 5' and the third bidirectional switch 8 to be an OFF state. Further, in the example, it is assumed that an AC 200 V is applied as the voltage of the alternating current power supply 1 and a constant load of 100 W is connected as a load 15.

In Fig. 7, (a) shows a voltage of an alternating current power supply 1, (b) a current of the alternating current power supply 1, (c) a control signal of the first bidirectional switch equivalent module 4' output from the control means 19, (d) a control signal of the second bidirectional switch equivalent module 5' output from the control means 19, (e) a control signal of the third bidirectional switch 8 output from the control means 19, (f) a voltage across both ends of a resistor 6, (g) a voltage across both ends of a resistor 7, (h) a voltage between terminals of a capacitor 9, and (i) shows a voltage between terminals of a capacitor 10. Further, in (f) to (i), a voltage between the output terminals of a rectifier 3 is described as well.

When only the diode 4a in the first bidirectional switch equivalent module 4' is in short circuit failure, a different voltage appears between both ends of the resistors 6 and 7 depending on a voltage state of the alternating current power supply 1 as shown in (f) and (g) of Fig. 7. This is because when the alternating current power supply 1 has a negative polarity and the absolute value of the voltage of the alternating current power supply 1 > the voltage across both ends of the resistor 6, a state occurs in which a current flows along a path in the order of the alternating current power supply 1, the diode 3b, the resistor 6, the diode 4b, the diode 4a (short circuit failure), the reactor 2, and the alternating current power supply 1. That is, since a voltage approximately equal to the voltage of the alternating current power supply 1 is applied across both ends of the resistor 6, the voltage across both ends of the resistor 6 becomes higher than the voltage across both ends of the resistor 7.

Likewise, when at least one of the parts 4a-4e constituting the first bidirectional switch equivalent module 4' is in short circuit failure or when at least one of the parts 5a-5e constituting the second bidirectional switch equivalent module 5' is in short circuit failure, a different voltage appears across both ends of the resistors 6 and 7. Accordingly, when the control means 19 controls the first and second bidirectional switch equivalent modules 4' and 5' and the third bidirectional switch 8 to be the OFF state and the absolute value of the difference between the voltages across both ends of the resistor 6 and the voltages across both ends of the resistor 7 is equal to or larger than a predetermined value (for example 50V), the abnormality detection means 20 can judge that the first bidirectional switch equivalent module 4' or the second bidirectional switch equivalent module 5' is in short circuit failure.

It is explained above to detect a short circuit failure of each bidirectional switch equivalent module based on the voltages across both ends of the resistors 6 and 7. On the contrary, it is also considered to detect that the short circuit failure of each bidirectional switch equivalent module based on the voltage across both ends of the capacitors 9 and 10 in place of the above. However, even if the voltage between terminals of the capacitors 9 and 10 are detected, almost no difference is created between the voltages between terminals of the capacitors 9 and 10 regardless of whether the first and second bidirectional switch equivalent modules 4' and 5' are in short circuit failure or not as can be found from (h) and (i) of Figs. 3 to 5 (however, the control signals of the first and second bidirectional switches 4 and 5 must be replaced with the control signals of the first and second bidirectional switch equivalent modules 4' and 5', respectively) and from (h) and (i) of Fig. 7. Accordingly, it is difficult to detect the short circuit failure of the first bidirectional switch equivalent module 4' or the second bidirectional switch equivalent module 5 based on the voltages between terminals.

As described above, according to Embodiment 2, even if the bidirectional switch is realized by the bidirectional switch equivalent module composed of a combination of the diodes and the switching element, the same advantage as that of the AC/DC converter of Eembodiment 1 can be realized.

### Embodiment 3

In Embodiment 3 of the present invention, a method of detecting a short circuit failure and an open circuit failure of the first, second, and third bidirectional switches 4, 5, and 8 will be explained. The circuit configuration of an AC/DC converter according to Embodiment 3 is the same as that in Fig. 1 explained in Embodiment 1 or that in Fig. 6 explained in Embodiment 2. The circuit configuration of Fig. 1 is used in the following explanation.

An abnormality detection means 20 detects the short circuit failure and the open circuit failure of the first, second, and third bidirectional switches 4, 5, and 8 based on the voltage values detected by first and second voltage detectors 16 and 17 and a voltage command value applied externally. When the abnormality detection means 20 detects the short circuit failure or the open circuit failure of the first, second, and third bidirectional switches 4, 5, and 8, an abnormality notification means 21 informs of abnormalities.

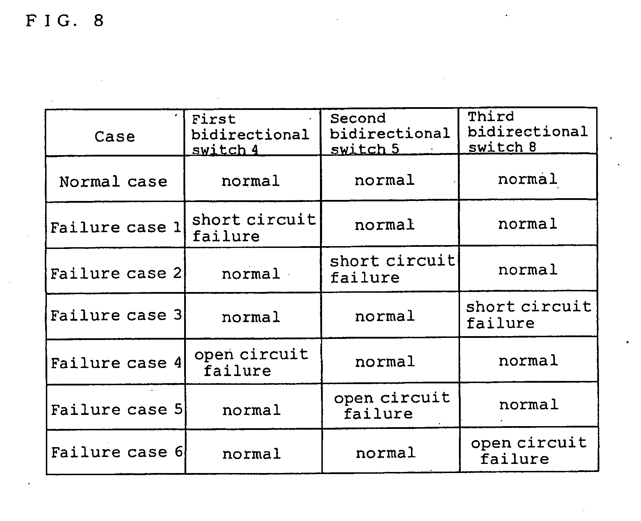

Fig. 8 is a table enumerating cases in which any one of the first, second, and third bidirectional switches 4, 5, and 8 is in short circuit failure or open circuit failure. As shown in Fig. 8, the failure includes six cases. Methods of detecting the respective cases of the failure will be explained below.

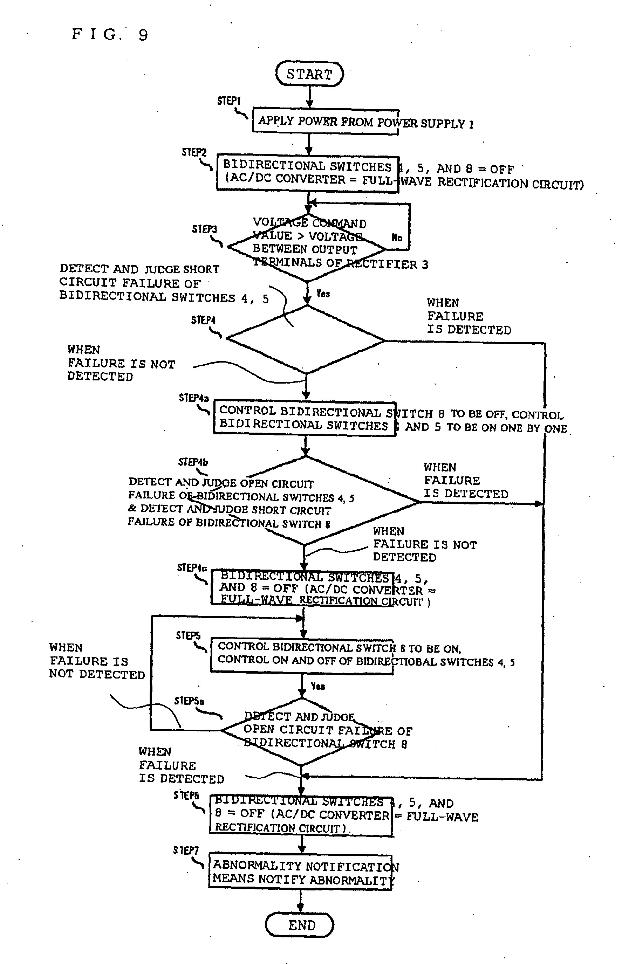

Fig. 9 is an operation flow of the AC/DC converter according to Embodiment 3. Since the operation flow of Fig. 9 is obtained by adding STEPs 4a to 4c and 5a to that of Fig. 2, the same steps as Fig. 2 are denoted by the same step numbers. Each step of Fig. 9 will be explained by focusing on points different from Fig. 2.

### (STEP 4a)

When the abnormality detection means 20 does not detect the short circuit failure of the first bidirectional switch 4 or the second bidirectional switch 5 at STEP 4, control means 19 controls the first and second bidirectional switches 4 and 5 to be an ON state one by one while controlling the third bidirectional switch 8 to be an OFF state.

### (STEP 4b)

The abnormality detection means 20 performs open circuit failure judgment of the first and second bidirectional switches 4 and 5 and short circuit failure judgment of the third bidirectional switch 8 under the state of STEP 4a.

### (STEP 4c)

When the abnormality detection means 20 does not detect the open circuit failure of the first and second bidirectional switches 4 and 5 and the short circuit failure of the third bidirectional switch 8 at STEP 4b, the control means 19 controls the first, second, and third bidirectional switches 4, 5, and 8 to be the OFF state once.

### (STEP 5a)

When the control means 19 controls the third bidirectional switch 8 to be the ON state and controls ON and OFF of the first and second bidirectional switches 4 and 5 so that the voltage between the output terminals of a rectifier 3 becomes the voltage command value applied externally at STEP 5, the abnormality detection means 20 judges whether or not the third bidirectional switch 8 is in open circuit failure. When the abnormality detection means 20 does not detect the open circuit failure of the third bidirectional switch 8, the flow returns to STEP 5.

### (STEP 6)

When at least one of the short circuit failure or the open circuit failure of the first, second, and third bidirectional switches 4, 5, and 8 is detected at STEPs 4, 4b, and 5a, the control means 19 controls the first, second, and third bidirectional switches 4, 5, and 8 to be the OFF state.

The operation flow of the AC/DC converter according to Embodiment 3 is explained as described above. Next, failure detection methods at STEPs 4, 4b, and 5a will be explained.

### (1) Method of detecting short circuit failure at STEP 4:

A method of detecting the short circuit failure of the first bidirectional switch 4 or the second bidirectional switch 5 by the abnormality detection means 20 at STEP 4 is the same as that of the AC/DC converter of Embodiment 1. That is, when the control means 19 controls the first, second, and third bidirectional switches 4, 5, and 8 to be the OFF state and the absolute value of the difference between the voltage of both ends of the resistor 6 and the voltage of both ends of the resistor 7 is equal to or larger than a predetermined value, the abnormality detection means 20 judges that the first bidirectional switch 4 or the second bidirectional switch 5 is in short circuit failure.

### (2) Method of detecting open circuit failure at STEP 4b:

When the absolute value of the difference between the voltages between both ends of the resistor 6 and the voltage of both ends of the resistor 7 is not equal to or larger than a predetermined value at the time the control means 19 controls the third bidirectional switch 8 to be the OFF state and the first and second bidirectional switches 4 and 5 to be the ON state one by one, the abnormality detection means 20 judges that the first bidirectional switch 4 or the second bidirectional switch 5 is in open circuit failure. The reason why the method is used will be explained below.

When the control means 19 controls the second and third bidirectional switches 5 and 8 to be the OFF state and the first bidirectional switch 4 to be the ON state, and the first, second, and third bidirectional switches 4, 5, and 8 are normal (a normal case of Fig. 8), voltages as shown in (f) and (g) of Fig. 4 appear across both ends of the resistors 6 and 7, respectively.

Further, when the control means 19 controls the first and third bidirectional switches 4 and 8 to be the OFF state and the second bidirectional switch 5 to be the ON state, and the first, second, and third bidirectional switches 4, 5, and 8 are normal (a normal case of Fig. 8), voltages as shown in (f) and (g) of Fig. 5 appear across both ends of the resistors 6 and 7, respectively.

On the other hand, when the control means 19 controls the second and third bidirectional switches 5 and 8 to be the OFF state and the first bidirectional switch 4 to be the ON state, and the first bidirectional switch 4 is in open circuit failure and the second and third bidirectional switches 5 and 8 are normal (a failure case 4 of Fig. 8), voltages as shown in (f) and (g) of Fig. 3 appear across both ends of the resistors 6 and 7, respectively.

Further, when the control means 19 controls the first and third bidirectional switches 4 and 8 to be the OFF state and the second bidirectional switch 5 to be the ON state, and the second bidirectional switch 5 is in open circuit failure and the first and third bidirectional switches 4 and 8 are normal (a failure case 5 of Fig. 8), voltages as shown in (f) and (g) of Fig. 3 also appear across both ends of the resistors 6 and 7, respectively.

Accordingly, when the control means 19 controls the third bidirectional switch 8 to be the OFF state and the first and second bidirectional switches 4 and 5 to be the ON state one by one, and the absolute value of the difference between the voltages across both ends of the resistors 6 and 7 is not equal to or larger than a predetermined value (for example, 50V), the abnormality detection means 20 can judge that the first bidirectional switch 4 or the second bidirectional switch 5 is in open circuit failure.

### (3) Method of detecting short circuit failure at STEP 4b:

When the voltage across the output terminals of a rectifier 3 becomes higher than the voltage value before STEP 4a by a predetermined value or more at the time the control means 19 controls the third bidirectional switch 8 to be the OFF state and the first and second bidirectional switches 4 and 5 to be the ON state one by one, the abnormality detection means 20 judges that the third bidirectional switch 8 is in short circuit failure. The reason why the method is used will be explained below. In addition, the voltage across the output terminals of the rectifier 3 can be obtained from the sum of the voltages detected by the first and second voltage detectors 16 and 17.

When the third bidirectional switch 8 is in short circuit failure and the first and second bidirectional switches 4 and 5 are normal (a failure case 3 of Fig. 8) at the time the control means 19 controls the third bidirectional switch 8 to be the OFF state and the first and second bidirectional switches 4 and 5 to be the ON state one by one, the AC/DC conversion circuit becomes a voltage-doubler circuit. Accordingly, the voltage across the output terminals of the rectifier 3 becomes higher than the voltage value before STEP 4.

Accordingly, when the voltage across the output terminals of the rectifier 3 becomes higher than the voltage value before STEP 4a by a predetermined value or more at the time the control means 19 controls the third bidirectional switch 8 to be the OFF state and the first and second bidirectional switches 4 and 5 to be the ON state one by one, the abnormality detection means 20 can judge that the third bidirectional switch 8 is in short circuit failure.

### (4) Method of detecting open circuit failure at STEP 5:

When the voltage across the output terminals of the rectifier 3 does not reach the voltage command value applied externally at the time the control means 19 controls the third bidirectional switch 8 to be the ON state and performs ON and OFF control of the first and second bidirectional switches 4 and 5 so that the voltage across the output terminals of the rectifier 3 becomes the voltage command value applied externally, the abnormality detection means 20 judges that the third bidirectional switch 8 is in open circuit failure. The reason why the method is used will be explained below. In addition, the voltage across the output terminals of the rectifier 3 can be determined by the sum of the voltages detected by the first and second voltage detectors 16 and 17.

When the third bidirectional switch 8 is in open circuit failure and the first and second bidirectional switches 4 and 5 are normal (a failure case 6 of Fig. 8) at the time the control means 19 controls the third bidirectional switch 8 to be the ON state and performs ON and OFF control of the first and second bidirectional switches 4 and 5 so that the voltage across the output terminals of the rectifier 3 becomes the voltage command value applied externally, a state does not occur in which the AC/DC conversion circuit becomes the voltage-doubler circuit. Accordingly, the voltage across the output terminals of the rectifier 3 does not reach the voltage command value applied externally.

Accordingly, when the voltage across the output terminals of the rectifier 3 does not reach the voltage command value applied externally at the time the control means 19 controls the third bidirectional switch 8 to be the ON state and performs ON and OFF control of the first and second bidirectional switches 4 and 5 so that the voltage across the output terminals of the rectifier 3 is made to the voltage command value applied externally, the abnormality detection means 20 can judge that the third bidirectional switch 8 is in open circuit failure.

The failure detection methods at STEPS 4, 4b, and 5a are explained above. In addition, failure cases 1 and 2 of Fig. 8 can be detected at STEP 4 like Embodiment 1.

Although Embodiment 3 the methods of detecting all the short circuit failures and open circuit failures of the first, second, and third bidirectional switches 4, 5, and 8, is described, only part of them may be detected.

Although it is configured that the voltages across both ends of the resistors 6 and 7 are detected in Embodiment 3, needless to say that the same processing can be realized when at least two voltage values of the voltages across both ends of the resistors 6 and 7 and the voltage across the output terminals of the rectifier 3 can be detected.

Further, when the abnormality detection means 20 judges that the first bidirectional switches 4 or the second bidirectional switch 5 is in short circuit failure, it may judge that the first bidirectional switch 4 or the second bidirectional switch 5 is in short circuit failure when the absolute value of the difference between one-half of the voltage across the output terminals of the rectifier 3 and the voltage across both ends of the resistors 6 or 7 becomes equal to or larger than a predetermined value.

Needless to say that the same advantage can be obtained even if each bidirectional switch is composed of a combination of the diode and the switching element as described in Embodiment 2.

As described above, according to Embodiment 3, by focusing on the waveforms of the voltages across both ends of the resistors 6 and 7 that appear when the respective bidirectional switches are in short circuit failure or open circuit failure, the abnormality detection means 20 can detect these failures.

Further, according to Embodiment 3, when the abnormality detection means 20 detects at least one of the short circuit failure or the open circuit failure of the first to third bidirectional switches, the control means 19 controls the first to third bidirectional switches to be the OFF state and operates the AC/DC converter as the full-wave rectifier circuit. Thereby, other elements and the like can be prevented from secondary damages.

### Embodiment 4

In Embodiment 4 of the present invention, other methods of detecting a short circuit failure and an open circuit failure of the first, second, and third bidirectional switches 4, 5, and 8 will be explained. In addition, the circuit arrangement of an AC/DC converter according to Embodiment 4 is the same as that in Fig. 1 explained in Embodiment 1 or that in Fig. 6 explained in Embodiment 2. The circuit configuration of Fig. 1 is used in the following explanation.

An abnormality detection means 20 detects a short circuit failure and an open circuit failure of the first, second, and third bidirectional switches 4, 5, and 8 based on the voltage values detected by first and second voltage detectors 16 and 17 and a voltage command value applied externally. When the abnormality detection means 20 detects the short circuit failure or the open circuit failure of the first, second, and third bidirectional switches 4, 5, and 8, an abnormality notification means 21 informs of abnormalities.

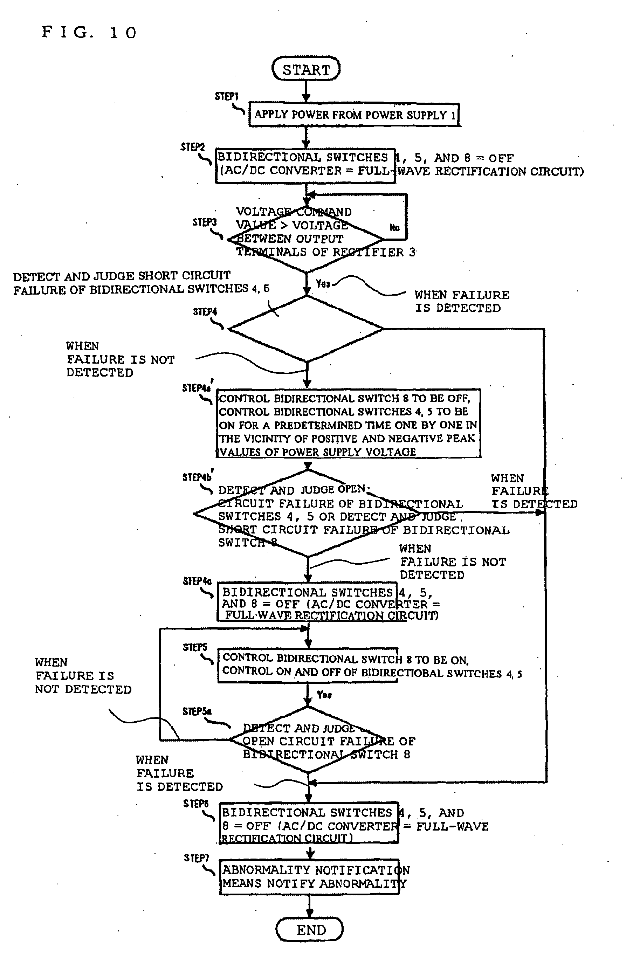

Fig. 10 is an operation flow of the AC/DC converter according to Embodiment 4. Since the operation flow in Fig. 10, STEPs 4a and 4b of Fig. 9 are changed to STEPs 4a' and 4b' in Fig. 10, and other steps are the same as Fig. 9, the same steps as Fig. 9 are denoted by the same step numbers. Each step of Fig. 10 will be explained below focusing on the points different from Fig. 9.

### (STEP 4a')

The control means 19 controls the first and second bidirectional switches 4 and 5 to be the ON state one by one for only a predetermined time (for example, 500 µs) in the vicinity of a positive peak value and a negative peak value of a power supply voltage based on the output of a power supply voltage zero cross detection circuit 18 while controlling the third bidirectional switch 8 to be an OFF state. The reason why the first and second bidirectional switches 4 and 5 are controlled to be the ON state only for the predetermined time (for example, 500 µs) is that if they are controlled to be the ON state for a long time under a state that the third bidirectional switch 8 is in short circuit failure, the AC/DC converter becomes a voltage-doubler circuit, so that a high voltage is applied across the output terminals of the rectifier 3 and puts a load on respective parts. To prevent the above problem, the first and second bidirectional switches 4 and 5 are controlled to be the ON state only for a short time in the present step.

### (STEP 4b')

In the state of STEP 4a', when the absolute value of the difference between the voltages across both ends of the resistors 6 and 7 is not equal to or larger than a predetermined value at the time the control means 19 controls the first bidirectional switch 4 or the second bidirectional switch 5 to be the ON state, the abnormality detection means 20 judges that the first bidirectional switch 4 or the second bidirectional switch 5 is in open circuit failure or the third bidirectional switch 8 is in short circuit failure.

The operation flow of the AC/DC converter according to Embodiment 4 is explained as described above. Next, a method of detecting a failure at STEP 4b' will be explained.

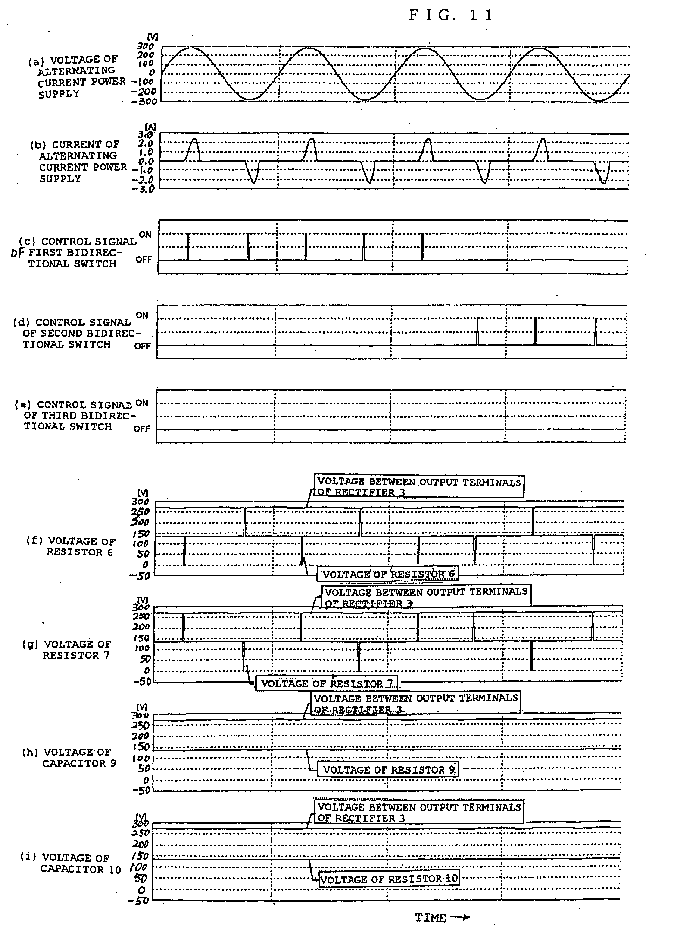

Figs. 11 to 14 are diagrams explaining waveforms of respective portions in detail when the first, second, and third bidirectional switches 4, 5, and 8 are normal, when the first bidirectional switch 4 or the second bidirectional switch 5 is in open circuit failure, and when the third bidirectional switch 8 is in short circuit failure, respectively.

Fig. 11 shows an example of the waveforms of each portion when the first, second, and third bidirectional switches 4, 5, and 8 are normal (a normal case of Fig. 8).

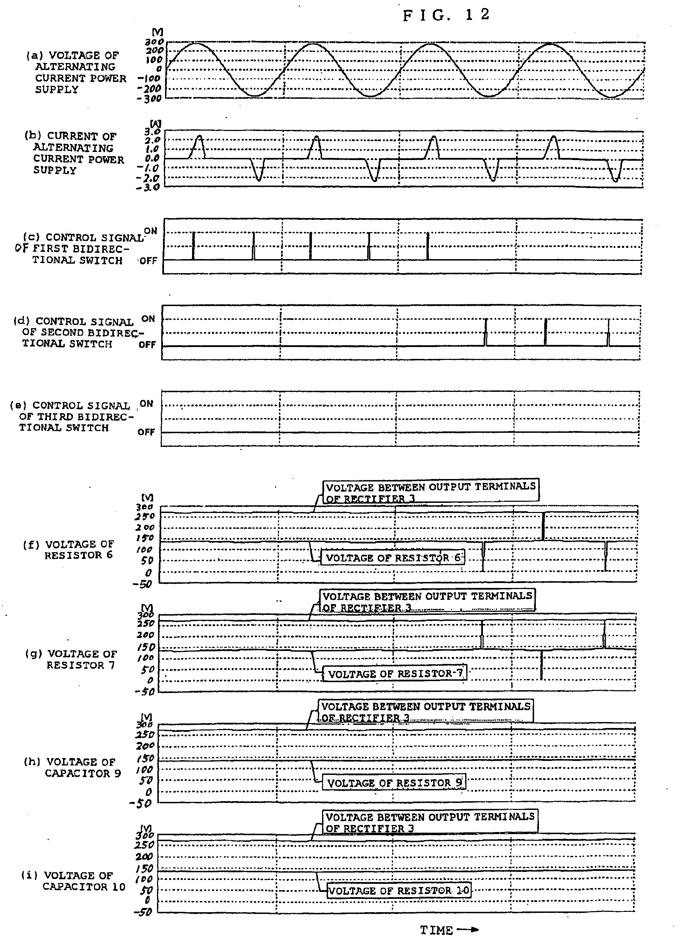

Fig. 12 shows an example of the waveforms of each portion when the first bidirectional switch 4 is in open circuit failure and the second and third bidirectional switches 5 and 8 are normal (a failure case 4 of Fig. 8).

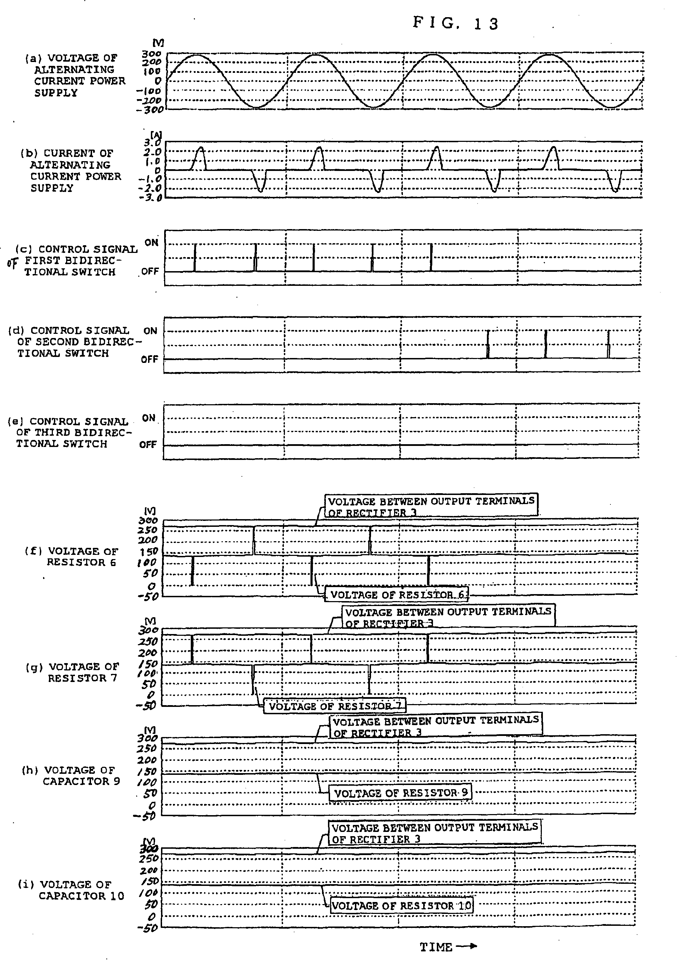

Fig. 13 shows an example of the waveforms of each portion when the second bidirectional switch 5 is in open circuit failure and the first and third bidirectional switches 4 and 8 are normal (a failure case 5 of Fig. 8).

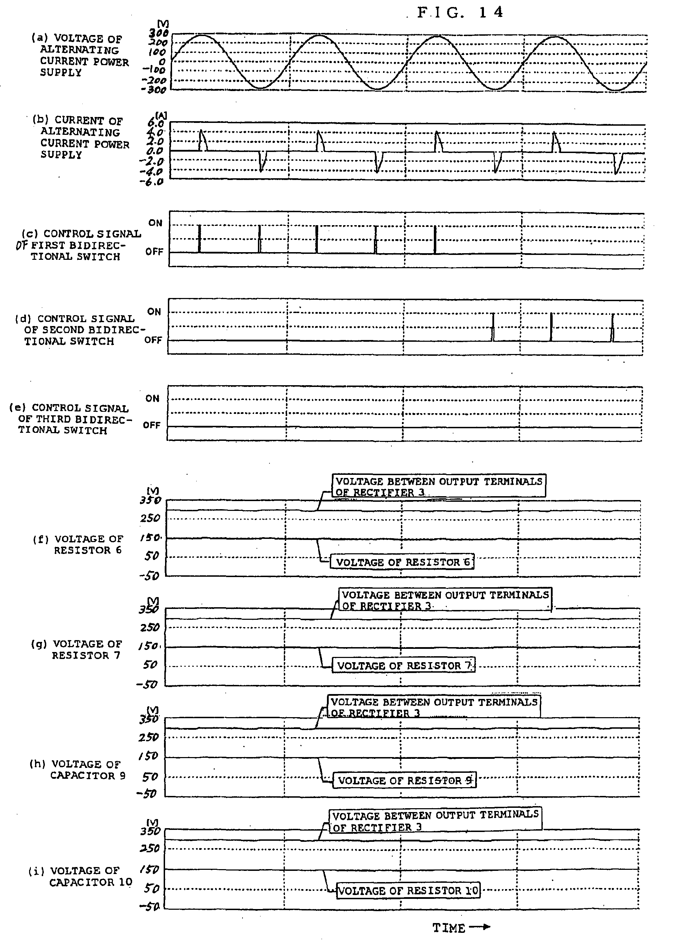

Fig. 14 shows an example of the waveforms of each portion when the third bidirectional switch 8 is in short circuit failure and the first and second bidirectional switches 4 and 5 are normal (a failure case 3 of Fig. 8).

In these examples, it is assumed that AC 200 V is applied as the voltage of an alternating current power supply 1 and a constant load of 100 W is connected as a load 15.

In Figs. 11 to 14, (a) shows a voltage of the alternating current power supply 1, (b) a current of the alternating current power supply 1, (c) a control signal of the first bidirectional switch 4 output from the control means 19, (d) a control signal of the second bidirectional switch 5 output from control means 19, (e) a control signal of the third bidirectional switch 8 output from the control means 19, (f) a voltage across both ends of a resistor 6, (g) a voltage across both ends of a resistor 7, (h) a voltage between terminals of a capacitor 9, and (i) shows a voltage between terminals of a capacitor 10. Further, in (f) to (i), a voltage between output terminals of a rectifier 3 is described as well.

In the state of STEP 4a', when the first, second, and third bidirectional switches 4, 5, and 8 are normal at the time the control means 19 controls the first bidirectional switch 4 or the second bidirectional switch 5 to be the ON state, a different voltage appears across both ends of the resistors 6 and 7, respectively as shown in (f) and (g) of Fig. 11.

In the state of STEP 4a', when the first bidirectional switch 4 is in open circuit failure and the second and third bidirectional switches 5 and 8 are normal (a failure case 4 of Fig. 8) at the time the control means 19 controls the first bidirectional switch 4 to be the ON state, one-half of the voltage across the output terminals of the rectifier 3 flatly appears across both ends of the resistors 6 and 7 as shown in (f) and (g) of Fig. 12. This is because the first bidirectional switch 4 is in open circuit failure, so that even if the first bidirectional switch 4 is controlled to be the ON state in a first half section of Fig. 12, the first bidirectional switch 4 cannot be the ON state.

In the state of STEP 4a', when the second bidirectional switch 5 is in open circuit failure and the first and third bidirectional switches 4 and 8 are normal (a failure case 5 of Fig. 8) at the time the control means 19 controls the second bidirectional switch 5 to be the ON state, one-half of the voltage across the output terminals of the rectifier 3 flatly appears across both ends of the resistors 6 and 7 as shown in (f) and (g) of Fig. 13. This is because since the second bidirectional switch 5 is in open circuit failure, so that even if the second bidirectional switch 5 is controlled to be the ON state in a last half section of Fig. 13, the second bidirectional switch 5 cannot be the ON state.

In the state of STEP 4a', when the third bidirectional switch 8 is in short circuit failure and the first and second bidirectional switches 4 and 5 are normal (a failure case 3 of Fig. 8) at the time the control means 19 controls the first bidirectional switch 4 or the second bidirectional switch 5 to be the ON state, one-half of the voltage across the output terminals of the rectifier 3 flatly appears across both ends of the resistors 6 and 7 as shown in (f) and (g) of Fig. 14.

Accordingly, in the state of STEP 4a', when the absolute value of the difference between the voltages across both ends of the resistors 6 and 7 is not equal to or larger than a predetermined value (for example, 50V) at the time the control means 19 controls the first bidirectional switch 4 or the second bidirectional switch 5 to be the ON state, it can be judged that the first bidirectional switch 4 or the second bidirectional switch 5 is in open circuit failure or the third bidirectional switch 8 is in short circuit failure.

It is explained above to detect that each bidirectional switch is in short circuit failure or open circuit failure based on the voltages across both ends of the resistors 6 and 7. On the other hand, it is also considered to detect that each bidirectional switch are in short circuit failure or open circuit failure based on the voltages between terminals of the capacitors 9 and 10 in place of the above. However, even if voltages between terminals of the capacitors 9 and 10 are detected, almost no difference is generated between the voltages across terminals of the capacitors 9 and 10 even when that the first bidirectional switch 4 or the second bidirectional switch 5 is in open circuit failure or the third bidirectional switch 8 is in short circuit failure as can be found from (h) and (i) of Figs. 11 to 14. Accordingly, it is difficult to detect that the first bidirectional switch 4 or the second bidirectional switch 5 is in open circuit failure or the third bidirectional switch 8 is in open circuit failure based on these voltages between terminals.

The failure detection method in STEP 4b' is explained above. Failure cases 1 and 2 of Fig. 8 can be detected at STEP 4 like Embodiment 1. Further, a failure case 6 can be detected at STEP 5a.

Although Embodiment 4 explains the methods of detecting all the short circuit failures and open circuit failures of the first, second, and third bidirectional switches 4, 5, and 8, part of them may be detected.

In Embodiment 4, although it is configured to detect voltages across both ends of the resistors 6 and 7, needless to say that the same processing can be realized when at least two voltage values of the voltages across both ends of the resistors 6 and 7 and the voltage between the output terminals of the rectifier 3 can be detected.

When the control means 19 controls the first bidirectional switch 4 or the second bidirectional switch 5 to be the ON state in the state of STEP 4a' at the time the abnormality detection means 20 judges that the first bidirectional switch 4 or the second bidirectional switch 5 is in open circuit failure or the third bidirectional switch 8 is in short circuit failure, the abnormality detection means 20 may judge that the first bidirectional switch 4 or the second bidirectional switch 5 is in open circuit failure or the third bidirectional switch 8 is in short circuit failure when the absolute value of the difference between one-half of the voltage between the output terminals of the rectifier 3 and the voltage across both ends the resistor 6 or 7 is not equal to or larger than a predetermined value.

Needless to say that the same effect can be obtained even if each bidirectional switch is composed of a combination of diodes and a switching elements as explained in Embodiment 2.

As described above, Embodiment 4 can exhibit the same advantage as that of Embodiment 3.

Further, according to Embodiment 4, at STEP 4a', the control means 19 controls the first and second bidirectional switches 4 and 5 to be the ON state one by one for only a predetermined time in the vicinity of a positive peak value and a negative peak value of a power supply voltage based on the output of a power supply voltage zero cross detection circuit 18. Accordingly, when a short circuit failure and an open circuit failure are judged, a load applied to respective parts can be suppressed.

In the above embodiments, when a failure is judged by comparing a detected value with a predetermined value, the judgment can be executed as described below in, for example, (1) and (2).
(1) An instantaneous value of a detected value is compared with a predetermined value, and when the instant value exceeds the predetermined value, it is determined that a failure occurs.
(2) It is judged that a failure occurs when the instantaneous value exceeds the predetermined value for a predetermined number of times within a predetermined time period (for example, several tens of milliseconds) in consideration of variations of detection.

### Embodiment 5

The AC/DC converter explained in Embodiments 1 to 4 can be used as an apparatus for converting direct current power to alternate current power to supply a direct current voltage to an inverter for driving a motor. It is also possible to configure a compressor driving apparatus for driving a compressor using the motor and further to configure an air conditioner for circulating a refrigerant using the compressor.

Further, with these configurations, it is also possible to notify a short circuit failure and an open circuit failure occurred in the AC/DC converter to the compressor driving apparatus and the air conditioner to execute operations for suppressing an operation range and the like.

1 alternating current power supply, 2 reactor, 3 rectifier, 4 first bidirectional switch, 5 second bidirectional switch, 6,7 resistor, 8 third bidirectional switch, 9,10 capacitor, 11,12 balance resistor, 13,14 clamp diode, 15 load, 16 first voltage detector, 15 second voltage detector, 18 power supply voltage zero cross detection circuit, 19 control means, 20 abnormality detection means, 21 abnormality notification means.

## Claims

1. An AC/DC converter comprising:
a rectifier (3) connected to an alternating current power supply (1) through a reactor (2);
a series resistor circuit composed of resistors (6,7) connected in series between the output terminals of the rectifier (3);
a capacitor series circuit composed of capacitors (9,10) connected in series between the output terminals of the rectifier (3);
a first bidirectional switch (4) having one end connected to one input terminal of the rectifier (3);
a second bidirectional switch (5) having one end connected to the other input terminal of the rectifier (3);
a third bidirectional switch (8) having one end connected to a junction of the resistors (6,7) and the other end connected to the junction of the capacitors (9,10);
control means (19) for controlling the operation of the first bidirectional switch (4), the second bidirectional switch (5), and the third bidirectional switch (8);
voltage detection means (16,17) for detecting at least two voltage values of the voltage of the resistor connected to a positive side of the output terminals of the rectifier (3), the voltage of the resistor connected to a negative side of the output terminals of the rectifier (3), and the voltage between the output terminals of the rectifier (3); and abnormality detection means (20) for detecting a failure of at least one of the first bidirectional switch (4) or the second bidirectional switch (5), wherein:
the other end of the first bidirectional switch (4) and the other end of the second bidirectional switch (5) are connected to the junction of the resistors (6,7); and
the abnormality detection means (20) detects the failure based on a result of detection of the voltage detection means (16,17).

2. The AC/DC converter of claim 1, wherein the abnormality detection means (20) judges that the first bidirectional switch (4) or the second bidirectional switch (5) is in short circuit failure when the absolute value of the difference between the voltage of the resistor connected to the positive side of the output terminal of the rectifier (3) and the voltage of the resistor connected to the negative side of the output terminal of the rectifier (3) is equal to or larger than a predetermined value or when the absolute value of the difference between one-half voltage of the voltage between the output terminals of the rectifier (3) and the voltage of the resistor is equal to or larger than a predetermined value at the time the control means (19) controls the first bidirectional switch (4), the second bidirectional switch (5), and the third bidirectional switch (8) to be an OFF state.

3. The AC/DC converter of claim 1 or 2, wherein the abnormality detection means (20) detects an open circuit failure of at least either of the first bidirectional switch (4) or the second bidirectional switch (5) based on a result of detection of the voltage detection means (16,17).

4. The AC/DC converter of claim 3, wherein:
the control means (19) controls the third bidirectional switch (8) to be the OFF state and controls the first bidirectional switch (4) or the second bidirectional switch (5) to be an ON state; and
the abnormality detection means (20) judges that the open circuit failure occurs when the absolute value of the difference between the voltage of the resistor connected to the positive side of the output terminal of the rectifier (3) and the voltage of the resistor connected to the negative side of the output terminal of the rectifier (3) is not equal to or larger than the predetermined value or when the absolute value of the difference between the one-half voltage of the voltage between the output terminals of the rectifier (3) and the voltage of the resistor is not equal to or larger than the predetermined value.

5. The AC/DC converter of any of claims 1 to 4, wherein the abnormality detection means (20) detects a short circuit failure of the third bidirectional switch (8) based on a result of detection of the voltage detection means (16,17).

6. The AC/DC converter of claim 5, wherein:
the control means (19) controls the third bidirectional switch (8) to be the OFF state and alternately controls the first bidirectional switch (4) and the second bidirectional switch (5) to be the ON state; and
the abnormality detection means (20) judges that the third bidirectional switch (8) is in short circuit failure when the absolute value of the difference between the voltage of the resistor connected to the positive side of the output terminal of the rectifier (3) and the voltage of the resistor connected to the negative side of the output terminal of the rectifier (3) rises higher than a predetermined value approximately at the time when the first bidirectional switch (4) and the second bidirectional switches (5) alternately start an ON operation.

7. The AC/DC converter of any of claims 1 to 6, wherein the abnormality detection means (20) detects an open circuit failure of the third bidirectional switch (8) based on a result of detection of the voltage detection means (16,17).

8. The AC/DC converter of claim 7, wherein:
the control means (19) controls the third bidirectional switch (8) to be the ON state so that the voltage between the output terminals of the rectifier (3) becomes a target value; and
the abnormality detection means (20) judges that the third bidirectional switch (8) is in open circuit failure when the voltage between the output terminals of the rectifier (3) does not reach a target value even if the first bidirectional switch (4) and the second bidirectional switch (5) perform ON/OFF control.

9. The AC/DC converter of any of claims 1 to 8, comprising:
zero cross detection means (18) for detecting a zero cross point of the voltage of the alternating current power supply (1), wherein
the control means (19) detects a positive peak and the negative peak of the alternating current power supply (1) based on a result of detection of the zero cross detection means (18) and turns on the first bidirectional switch (4) and the second bidirectional switch (5) only at each peak.

10. The AC/DC converter of any of claims 1 to 9, wherein when the abnormal detection means (20) detects that the first bidirectional switch (4), the second bidirectional switch (5), or the third bidirectional switch (8) fails, the control means (19) turns OFF the first bidirectional switch (4), the second bidirectional switch (5), and the third bidirectional switch (8).

11. The AC/DC converter of any of claims 1 to 10 comprising abnormality notification means (21) for notifying that the first bidirectional switch (4), the second bidirectional switch (5), or the third bidirectional switch (8) fails based on a result of detection of the abnormality detection means (20).

12. The AC/DC converter of any of claims 1 to 11, wherein the first bidirectional switch (4) and the second bidirectional switch 5) are composed using diodes and switching elements.

13. A compressor driving apparatus comprising:
the AC/DC converter of any of claims 1 to 12; and
an inverter for driving a motor by converting direct current power output from the AC/DC converter to alternating power,
wherein the motor drives a compressor.

14. The compressor driving apparatus of claim 13, wherein when the abnormal detection means (20) detects that the first bidirectional switch (4), the second bidirectional switch (5), or the third bidirectional switch (8) fails, the control means (19) controls the first bidirectional switch (4), the second bidirectional switch (5), and the third bidirectional switch (8) to be OFF state and restricts the operation range of the compressor.

15. An air conditioner, wherein a refrigerant is circulated by the compressor driving apparatus of claim 13 or 14.

## Patentansprüche

1. AC/DC-Wandler aufweisend:
einen Gleichrichter (3), der mit einer Wechselstrom-Leistungsversorgung (1) über eine Drosselspule (2) verbunden ist;
eine Reihenwiderstandsschaltung, die zusammengesetzt ist aus zwischen den Ausgangsanschlüssen des Gleichrichters (3) in Serie verbundenen Widerständen (6, 7);
eine Kondensatorreihenschaltung, die zusammengesetzt ist aus zwischen den Ausgangsanschlüssen des Gleichrichters (3) in Serie verbundenen Kondensatoren;
einen ersten bidirektionalen Schalter (4), der mit einem Ende mit einem Eingangsanschluss des Gleichrichters (3) verbunden ist;
einen zweiten bidirektionalen Schalter (5), der mit einem Ende mit dem anderen Eingangsanschluss des Gleichrichters (3) verbunden ist;
einen dritten bidirektionalen Schalter (8), der mit einem Ende mit einer Kontaktstelle der Widerstände (6, 7) verbunden ist und mit dem anderen Ende mit der Kontaktstelle der Kondensatoren (9, 10) verbunden ist;
Kontrollmittel (19) zum Kontrollieren des Betriebs des ersten bidirektionalen Schalters (4), des zweiten bidirektionalen Schalters (5) und des dritten bidirektionalen Schalters (8);
Spannungsdetektionsmittel (16, 17) zum Detektieren zumindest zweier Spannungswerte der Spannung des Widerstands, der mit einer positiven Seite der Ausgangsanschlüsse des Gleichrichters (3) verbunden ist, der Spannung des Widerstandes, der mit einer negativen Seite der Ausgangsanschlüsse des Gleichrichters (3) verbunden ist und der Spannung zwischen den Ausgangsanschlüssen des Gleichrichters (3);
und Auffälligkeits-Detektionsmittel (20) zum Detektieren einer Störung zumindest eines von dem ersten bidirektionalen Schalter (4) oder dem zweiten bidirektionalen Schalter (5), wobei:
das andere Ende des ersten bidirektionalen Schalters (4) und das andere Ende des zweiten bidirektionalen Schalters (5) mit der Kontaktstelle der Widerstände (6, 7) verbunden sind; und
die Auffälligkeits-Detektionsmittel (20) die Störung basierend auf einem Ergebnis der Detektion der Spannungsdetektionsmittel (16, 17) detektiert.

2. AC/DC-Wandler nach Anspruch 1, wobei das Auffälligkeits-Detektionsmittel (20) urteilt, dass der erste bidirektionale Schalter (4) oder der zweite bidirektionale Schalter (5) in einer Kurzschlussstörung ist, wenn der Absolutwert der Differenz zwischen der Spannung des Widerstands, der mit der positiven Seite des Ausgangsanschlusses des Gleichrichters (3) verbunden ist, und der Spannung des Widerstands, der mit der negativen Seite des Ausgangsanschlusses des Gleichrichters (3) verbunden ist, gleich oder größer ist als ein vorbestimmter Wert, oder wenn der Absolutwert der Differenz zwischen halber Spannung der Spannung zwischen den Ausgangsanschlüssen des Gleichrichters (3) und der Spannung des Widerstandes gleich oder größer ist als ein vorbestimmter Wert zu der Zeit, zu der das Kontrollmittel (19) den ersten bidirektionalen Schalter (4), den zweiten bidirektionalen Schalter (5) und den dritten bidirektionalen Schalter (8) kontrolliert, in einem AUS-Zustand zu sein.

3. AC/DC-Wandler nach Anspruch 1 oder 2, wobei das Auffälligkeits-Detektionsmittel (20) einen Offener-Kreislauf-Defekt zumindest entweder des ersten bidirektionalen Schalters (4) und des zweiten bidirektionalen Schalters (5) basierend auf einem Ergebnis der Detektion der Spannungsdetektionsmittel (16, 17) detektiert.

4. AC/DC-Wandler nach Anspruch 3, wobei:
das Kontrollmittel (19) den dritten bidirektionalen Schalter (8) kontrolliert, in einem AUS-Zustand zu sein, und den ersten bidirektionalen Schalter (4) oder den zweiten bidirektionalen Schalter (5) kontrolliert, in einem AN-Zustand zu sein; und
das Auffälligkeits-Detektionsmittel (20) urteilt, dass der Offener-Schaltkreis-Defekt auftritt, wenn der Absolutwert der Differenz zwischen der Spannung des Widerstands, der mit der positiven Seite des Ausgangsanschlusses des Gleichrichters (3) verbunden ist, und der Spannung des Widerstandes, der mit der negativen Seite des Ausgangsanschlusses des Gleichrichters (3) verbunden ist, nicht gleich ist oder größer ist als ein vorbestimmter Wert, oder wenn der Absolutwert der Differenz zwischen der halben Spannung der Spannung zwischen den Ausgangsanschlüssen des Gleichrichters (3) und der Spannung des Widerstandes nicht gleich oder größer ist als ein vorbestimmter Wert.

5. AC/DC-Wandler nach einem der Ansprüche 1 bis 4,
wobei das Auffälligkeits-Detektionsmittel (20) eine Kurzschlussstörung des dritten bidirektionalen Schalters (8) basierend auf einem Ergebnis der Detektion der Spannungsdetektionsmittel (16, 17) detektiert.

6. AC/DC-Wandler nach Anspruch 5, wobei:
das Kontrollmittel (19) den dritten bidirektionalen Schalter (8) kontrolliert, in einem AUS-Zustand zu sein, und alternierend den ersten bidirektionalen Schalter (4) und den zweiten bidirektionalen Schalter (5) kontrolliert, in einem AN-Zustand zu sein; und
das Auffälligkeits-Detektionsmittel (20) urteilt, dass der dritte bidirektionale Schalter (8) in einer Kurzschlussstörung ist, wenn der Absolutwert der Differenz zwischen der Spannung des Widerstandes, der mit der positiven Seite des Ausgangsanschlusses des Gleichrichters (3) verbunden ist und der Spannung des Widerstandes, der mit der negativen Seite des Ausgangsanschlusses des Gleichrichters (3) verbunden ist, höher steigt als ein vorbestimmter Wert näherungsweise zu der Zeit, wenn der erste bidirektionale Schalter (4) und der zweite bidirektionale Schalter (5) alternierend eine AN-Operation starten.

7. AC/DC-Wandler nach einem der Ansprüche 1 bis 6, wobei das Auffälligkeits-Detektionsmittel einen Offener-Schaltkreis-Defekt des dritten bidirektionalen Schalters (8) basierend auf einem Ergebnis der Detektion der Spannungsdetektionsmittel (16, 17) detektiert.

8. AC/DC-Wandler nach Anspruch 7, wobei:
das Kontrollmittel (19) den dritten bidirektionalen Schalter (8) kontrolliert, in einem AN-Zustand zu sein, so dass die Spannung zwischen den Ausgangsanschlüssen des Gleichrichters (3) ein Zielwert annimmt; und
das Auffälligkeits-Detektionsmittel (20) urteilt, dass der dritte bidirektionale Schalter (8) in einem Offener-Schaltkreis-Defekt ist, wenn die Spannung zwischen den Ausgangsanschlüssen des Gleichrichters (3) nicht den Zielwert erreicht, selbst wenn der erste bidirektionale Schalter (4) und der zweite bidirektionale Schalter (5) AN/AUS-Kontrolle durchführen.

9. AC/DC-Wandler nach einem der Ansprüche 1 bis 8, aufweisend:
Nulldurchgangs-Detektionsmittel (18) zum Detektieren eines Nulldurchgangspunktes der Spannung der Wechselstrom-Leistungsversorgung (1), wobei
das Kontrollmittel (19) eine positive Spitze und die negative Spitze der Wechselstrom-Leistungsversorgung (1) basierend auf einem Ergebnis der Detektion des Nulldurchgangs-Detektionsmittels (18) detektiert und den ersten bidirektionalen Schalter (4) und den zweiten bidirektionalen Schalter (5) nur an jedem Peak einschaltet.

10. AC/DC-Wandler nach einem der Ansprüche 1 bis 9,
wobei, wenn das Auffälligkeits-Detektionsmittel (20) detektiert, dass der erste bidirektionale Schalter (4), der zweite bidirektionale Schalter (5) oder der dritte bidirektionale Schalter (8) versagt, das Kontrollmittel (19) den ersten bidirektionalen Schalter (4), den zweiten bidirektionalen Schalter (5) und den dritten bidirektionalen Schalter (8) AUS schaltet.

11. AC/DC-Wandler nach einem der Ansprüche 1 bis 10, aufweisend:
Auffälligkeits-Benachrichtigungsmittel (21) zum Benachrichtigen, dass der erste bidirektionale Schalter (4), der zweite bidirektionale Schalter (5) oder der dritte bidirektionale Schalter (8) versagt, basierend auf einem Ergebnis der Detektion des Auffälligkeits-Detektionsmittels (20).

12. AC/DC-Wandler nach einem der Ansprüche 1 bis 11,
wobei der erste bidirektionale Schalter (4) und der zweite bidirektionale Schalter (5) unter Verwendung von Dioden und Schalterelementen zusammengesetzt sind.

13. Kompressorantriebsgerät aufweisend:
den AC/DC-Wandler nach einem der Ansprüche 1 bis 12; und
einen Wechselrichter zum Antreiben eines Motors durch Konvertieren von Gleichstrom-Leistungsausgabe von dem AC/DC-Wandler zu Wechselstrom, wobei der Motor einen Kompressor antreibt.

14. Kompressorantriebsgerät nach Anspruch 13,
wobei, wenn das Auffälligkeits-Detektionsmittel (20) detektiert, dass der erste bidirektionale Schalter (4), der zweite bidirektionale Schalter (5) oder der dritte bidirektionale Schalter (8) versagt, das Kontrollmittel (19) den ersten bidirektionalen Schalter (4), den zweiten bidirektionalen Schalter (5) und den dritten bidirektionalen Schalter (8) kontrolliert, im AUS-Zustand zu sein und den Arbeitsbereich des Kompressors einschränkt.

15. Klimaanlage, wobei ein Kältemittel durch das Kompressorantriebsgerät nach Anspruch 13 oder 14 zirkuliert wird.

## Revendications

1. Convertisseur AC / DC comprenant :
un redresseur (3) connecté à une alimentation électrique en courant alternatif (1) par l'intermédiaire d'une bobine (2) ;
un circuit à résisteurs en série composé de résisteurs (6, 7) connectés en série entre les bornes de sortie du redresseur (3) ;
un circuit à condensateurs en série composé de condensateurs (9, 10) connectés en série entre les bornes de sortie du redresseur (3) ;
un premier commutateur bidirectionnel (4) qui présente une extrémité connectée à une borne d'entrée du redresseur (3) ;
un deuxième commutateur bidirectionnel (5) qui présente une extrémité connectée à l'autre borne d'entrée du redresseur (3) ;
un troisième commutateur bidirectionnel (8) qui présente une extrémité connectée à une jonction des résisteurs (6, 7) et l'autre extrémité connectée à la jonction des condensateurs (9, 10) ;
des moyens de commande (19) destinés à commander le fonctionnement du premier commutateur bidirectionnel (4), du deuxième commutateur bidirectionnel (5), et du troisième commutateur bidirectionnel (8) ;
des moyens de détection de tension (16, 17) destinés à détecter deux valeurs de tension au moins de la tension du résisteur connecté à un côté positif des bornes de sortie du redresseur (3), de la tension du résisteur connecté à un côté négatif des bornes de sortie du redresseur (3), et de la tension présente entre les bornes de sortie du redresseur (3) ;
et des moyens de détection d'anomalie (20) destinés à détecter une défaillance de l'un au moins du premier commutateur bidirectionnel (4) ou du deuxième commutateur bidirectionnel (5), dans lequel :
l'autre extrémité du premier commutateur bidirectionnel (4) et l'autre extrémité du deuxième commutateur bidirectionnel (5) sont connectées à la jonction des résisteurs (6, 7) ; et
les moyen de détection d'anomalie (20) détectent la défaillance sur la base d'un résultat de détection des moyens de détection de tension (16, 17).

2. Convertisseur AC / DC selon la revendication 1, dans lequel les moyens de détection d'anomalie (20) jugent que le premier commutateur bidirectionnel (4) ou que le deuxième commutateur bidirectionnel (5) présente une défaillance de court-circuit lorsque la valeur absolue de la différence entre la tension du résisteur connecté au côté positif de la borne de sortie du redresseur (3) et la tension du résisteur connecté au côté négatif de la borne de sortie du redresseur (3), est égale ou supérieure à une valeur prédéterminée, ou lorsque la valeur absolue de la différence entre la moitié de la tension présente entre les bornes de sortie du redresseur (3) et la tension du résisteur est égale ou supérieure à une valeur prédéterminée lorsque les moyens de commande (19) commandent le premier commutateur bidirectionnel (4), le deuxième commutateur bidirectionnel (5), et le troisième commutateur bidirectionnel (8) de façon à ce qu'ils présentent un état HORS SERVICE.

3. Convertisseur AC / DC selon les revendications 1 ou 2, dans lequel les moyen de détection d'anomalie (20) détectent une défaillance de circuit ouvert de l'un au moins du premier commutateur bidirectionnel (4) ou du deuxième commutateur bidirectionnel (5) sur la base d'un résultat de détection des moyens de détection de tension (16, 17).

4. Convertisseur AC / DC selon la revendication 3, dans lequel :
les moyens de commande (19) commandent le troisième commutateur bidirectionnel (8) de façon à ce qu'il présente un état HORS SERVICE, et commandent le premier commutateur bidirectionnel (4) ou le deuxième commutateur bidirectionnel (5) de façon à ce qu'il présente un état EN SERVICE ; et
les moyens de détection d'anomalie (20) jugent que la défaillance de circuit ouvert se produit lorsque la valeur absolue de la différence entre la tension du résisteur connecté au côté positif de la borne de sortie du redresseur (3) et la tension du résisteur connecté au côté négatif de la borne de sortie du redresseur (3) n'est pas égale ou supérieure à la valeur prédéterminée, ou lorsque la valeur absolue de la différence entre la moitié de la tension présente entre les bornes de sortie du redresseur (3) et la tension du résisteur n'est pas égale ou supérieure à la valeur prédéterminée.

5. Convertisseur AC / DC selon l'une quelconque des revendications 1 à 4, dans lequel les moyen de détection d'anomalie (20) détectent une défaillance de court-circuit du troisième commutateur bidirectionnel (8) sur la base d'un résultat de détection des moyens de détection de tension (16, 17).

6. Convertisseur AC / DC selon la revendication 5, dans lequel :
les moyens de commande (19) commandent le troisième commutateur bidirectionnel (8) de façon à ce qu'il présente un état HORS SERVICE, et commandent alternativement le premier commutateur bidirectionnel (4) et le deuxième commutateur bidirectionnel (5) de façon à ce qu'il présentent l'état EN SERVICE ; et
les moyens de détection d'anomalie (20) jugent que le troisième commutateur bidirectionnel (8) présente une défaillance de court-circuit lorsque la valeur absolue de la différence entre la tension du résisteur connecté au côté positif de la borne de sortie du redresseur (3) et la tension du résisteur connecté au côté négatif de la borne de sortie du redresseur (3), excède une valeur prédéterminée approximativement au moment où le premier commutateur bidirectionnel (4) et le deuxième commutateur bidirectionnel (5) commencent alternativement un fonctionnement EN SERVICE.

7. Convertisseur AC / DC selon l'une quelconque des revendications 1 à 6, dans lequel les moyens de détection d'anomalie (20) détectent une défaillance de circuit ouvert du troisième commutateur bidirectionnel (8) sur la base d'un résultat de détection des moyens de détection de tension (16, 17).

8. Convertisseur AC / DC selon la revendication 7, dans lequel :
les moyens de commande (19) commandent le troisième commutateur bidirectionnel (8) de façon à ce qu'il présente l'état EN SERVICE de telle sorte que la tension entre les bornes de sortie du redresseur (3) présente une valeur cible ; et
les moyens de détection d'anomalie (20) jugent que le troisième commutateur bidirectionnel (8) présente une défaillance de circuit ouvert lorsque la tension entre les bornes de sortie du redresseur (3) n'atteint pas une valeur cible même si le premier commutateur bidirectionnel (4) et le deuxième commutateur bidirectionnel (5) exécutent une commande EN SERVICE / HORS SERVICE.

9. Convertisseur AC / DC selon l'une quelconque des revendications 1 à 8, comprenant :
des moyens de détection de passage par zéro (18) destinés à détecter un point de passage par zéro de la tension de l'alimentation électrique en courant alternatif (1), dans lequel :
les moyens de commande (19) détectent une crête positive et la crête négative de l'alimentation électrique en courant alternatif (1) sur la base d'un résultat de détection des moyens de détection de passage par zéro (18), et mettent EN SERVICE le premier commutateur bidirectionnel (4) et le deuxième commutateur bidirectionnel (5) seulement à chaque crête.

10. Convertisseur AC / DC selon l'une quelconque des revendications 1 à 9, dans lequel lorsque les moyens de détection d'anomalies (20) détectent que le premier commutateur bidirectionnel (4), le deuxième commutateur bidirectionnel (5), ou le troisième commutateur bidirectionnel (8) présente une défaillance, les moyens de commande (19) mettent HORS SERVICE le premier commutateur bidirectionnel (4), le deuxième commutateur bidirectionnel (5), et le troisième commutateur bidirectionnel (8).

11. Convertisseur AC / DC selon l'une quelconque des revendications 1 à 10 comprenant des moyens de notification d'anomalie (21) destinés à notifier que le premier commutateur bidirectionnel (4), le deuxième commutateur bidirectionnel (5), ou le troisième commutateur bidirectionnels (8) présente une défaillance sur la base d'un résultat de détection des moyens de détection d'anomalie (20).

12. Convertisseur AC / DC selon l'une quelconque des revendications 1 à 11, dans lequel le premier commutateur bidirectionnel (4) et le deuxième commutateur bidirectionnel 5) se composent de diodes et d'éléments de commutation.

13. Appareil d'entraînement de compresseur comprenant :
le convertisseur AC / DC selon l'une quelconque des revendications 1 à 12 ; et
un onduleur destiné à entraîner un moteur en convertissant le courant continu délivré en sortie par le convertisseur AC / DC en courant alternatif ;
dans lequel le moteur entraîne un compresseur.

14. Appareil d'entraînement de compresseur selon la revendication 13, dans lequel lorsque les moyens de détection d'anomalies (20) détectent que le premier commutateur bidirectionnel (4), le deuxième commutateur bidirectionnel (5), ou le troisième commutateur bidirectionnel (8) présente une défaillance, les moyens de commande (19) commandent le premier commutateur bidirectionnel (4), le deuxième commutateur bidirectionnel (5), et le troisième commutateur bidirectionnel (8) de façon à ce qu'ils présentent un état HORS SERVICE, et limitent la plage de fonctionnement du compresseur.

15. Climatiseur, dans lequel un agent réfrigérant est mis en circulation par l'appareil d'entraînement de compresseur selon les revendications 13 ou 14.
